(19) Europäisches Patentamt / European Patent Office / Office européen des brevets

(11) **EP 4 002 675 B1**

(12) **FASCICULE DE BREVET EUROPEEN**

(45) Date de publication et mention
de la délivrance du brevet:
**03.01.2024 Bulletin 2024/01**

(21) Numéro de dépôt: **21208696.1**

(22) Date de dépôt: **17.11.2021**

(51) Classification Internationale des Brevets (IPC):
*H02P 1/04* (2006.01)    *H02P 5/46* (2006.01)
*H02P 6/16* (2016.01)    *H02P 6/17* (2016.01)
*H02P 6/18* (2016.01)    *H02P 21/04* (2006.01)
*H02P 21/13* (2006.01)    *H02P 21/18* (2016.01)
*H02P 23/03* (2006.01)    *H02P 23/12* (2006.01)
*H02P 23/14* (2006.01)    *H02P 25/03* (2016.01)
*B64D 27/00* (2006.01)

(52) Classification Coopérative des Brevets (CPC):
**H02P 5/46; H02P 1/04; H02P 6/16; H02P 6/17;
H02P 6/18; H02P 21/04; H02P 21/13; H02P 21/18;
H02P 23/03; H02P 23/12; H02P 23/14; H02P 25/03**

(54) **PROCÉDÉ ET DISPOSITIF D'ESTIMATION DE LA POSITION D'UN ROTOR DE MACHINE ÉLECTRIQUE SYNCHRONE**

VERFAHREN UND VORRICHTUNG ZUR SCHÄTZUNG DER ROTORPOSITION EINER ELEKTRISCHEN SYNCHRONMASCHINE

METHOD AND APPARATUS FOR ESTIMATING THE POSITION OF A ROTOR OF A SYNCHRONOUS ELECTRIC MACHINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.11.2020 FR 2011885**

(43) Date de publication de la demande:
**25.05.2022 Bulletin 2022/21**

(73) Titulaire: **THALES
92400 Courbevoie (FR)**

(72) Inventeurs:
• **BECIU, Andreea-Livia
78400 CHATOU (FR)**
• **MAALOUF, Amira
78400 CHATOU (FR)**

(74) Mandataire: **Atout PI Laplace
Immeuble "Visium"
22, avenue Aristide Briand
94117 Arcueil Cedex (FR)**

(56) Documents cités:
**WO-A1-2012/143458    CN-A- 106 059 430
CN-A- 107 134 962    CN-A- 110 855 207
FR-A1- 2 897 730**

**Description**

L'invention concerne la commande des machines électriques tournantes. Plus particulièrement, l'invention concerne un procédé permettant l'estimation de la position d'un rotor d'une machine électrique tournante. L'invention est particulièrement adaptée à l'estimation de position d'un rotor de machine électrique tournante fonctionnant à basse vitesse ou à l'arrêt.

L'invention trouve une utilité particulière dans le domaine des machines tournantes fonctionnant sans capteur mécanique de position du rotor comme dans le domaine de l'aéronautique où la tendance actuelle est de limiter la masse embarquée au sein des avions.

Les machines électriques tournantes de type machine synchrone sans balai et à plusieurs étages sont utilisés à grande échelle dans le domaine de l'aéronautique. Par exemple, celles-ci peuvent être utilisées afin de fournir un fort couple lors des phases de démarrage des réacteurs auxquelles elles sont associées.

Ces nouveaux systèmes de motorisation nécessitent la connaissance, à tout moment, de la position du rotor pour l'élaboration des commandes performantes. Or, selon l'architecture des systèmes se servant de capteurs mécanique, la localisation de ces machines à proximité du réacteur représente une contrainte extrêmement sévère nécessitant des capteurs mécaniques fonctionnant dans un environnement portée à très haute température. Ainsi, l'utilisation de capteurs mécaniques sous ces contraintes extrêmes devient une contrainte pour la conception.

Par ailleurs, selon les types de machine synchrone utilisée, l'intégration mécanique du capteur de position du rotor au niveau de la machine peut être un réel problème. En effet, la compacité des machines synchrones actuelles souhaitée par les avionneurs, est un frein à l'insertion de tels capteurs.

D'autant plus que se passer d'un capteur de position mécanique permet un gain de masse liée à la suppression du capteur et à la réduction de nombre de câbles entre l'électronique destinée au démarrage et la machine électrique tournante.

A très basse vitesse et à l'arrêt, des techniques peuvent être utilisées pour estimer la position d'une machine électrique synchrone. Parmi ces techniques, l'injection de signaux à haute fréquence dans le stator ou au niveau du rotor permet d'induire une réponse en courant qui dépend de la position réelle du rotor.

Les méthodes d'injection de signaux à haute fréquence dans le stator sont usuellement employées pour l'estimation de la position du rotor mais elles présentent des inconvénients :

- l'injection des signaux à haute fréquence peut produire une perturbation au niveau du couple électromagnétique de la machine électrique tournante, sans que l'amplitude du courant utile contenant l'information de la position soit suffisante pour le traitement de cette donnée.
- les harmoniques produites à haute fréquence ne contiennent pas d'information sur la polarité réelle du rotor. Une séquence spéciale d'identification de la polarité est ainsi nécessaire.

L'injection de signaux à haute fréquence au niveau du stator présente donc des inconvénients dans un cas d'estimation de la position du rotor.

A l'inverse, l'injection de signaux à haute fréquence au niveau du rotor peut être envisagée du fait qu'elle permette une estimation de la position à partir d'un courant induit au niveau du stator qui contient l'information sur la position sans incertitude sur la polarité. En outre, l'ensemble des harmoniques induits au niveau du stator a une amplitude plus faible pour une même quantité de signaux injectés en comparaison avec une quelconque méthode d'injection au niveau du stator, ce qui implique des perturbations moins importantes. Cependant, certains éléments, comme par exemple les ponts redresseurs, rendent difficile l'injection d'un signal directement au niveau du rotor.

Les documents CN 106959430 A, CN 107134962 A et WO 2012/143458 A1 proposent ainsi un procédé d'estimation de la position du rotor.

Plus précisément, le document WO2012/143458 A1 divulgue un procédé d'estimation de position d'un rotor de machine électrique synchrone sans injection de signaux, comprenant un rotor et un stator, accouplée à une machine électrique synchrone inversée, comprenant un rotor et un stator, assurant le rôle d'excitatrice, par l'intermédiaire d'un redresseur, le redresseur étant connecté à l'excitation rotorique de la machine principale,le redresseur étant connecté au rotor de la machine électrique synchrone inversée, le procédé d'estimation comprenant les étapes suivantes:

a. Mesure d'un courant $i_{abc}$ circulant dans le stator de la machine électrique synchrone;
b. Détermination de deux signaux en quadrature selon un repère stationnaire à partir du courant $i_{abc}$ et isolation de deux signaux filtrés à partir des deux signaux en quadrature
c. Démodulation des deux signaux filtrés afin d'obtenir deux signaux démodulés;
d. Obtention d'une position estimée du rotor à partir des deux signaux démodulés.

L'invention vise à pallier tout ou partie des problèmes cités plus haut en proposant un procédé d'estimation de position d'un rotor à partir du courant statorique d'une machine électrique tournante par l'intermédiaire d'harmoniques existants naturellement dans le courant statorique de la machine électrique tournante. Cette estimation est donc obtenue sans modifier fortement le système existant et sans injection de signaux supplémentaires ni au rotor, ni au stator qui pourraient introduire des perturbations de couple. Une analyse des courants statoriques permet d'estimer la position directement sans incertitude sur la polarité et sans ajouter de mesures supplémentaires.

Ainsi, l'estimation de position est rendue robuste dans le contexte d'un avion plus électrique. L'invention permet d'améliorer la fiabilité du système global, ce qui représente un intérêt majeur, à titre d'exemple, dans le domaine de l'aéronautique où les systèmes avioniques doivent être le plus fiable possible.

L'invention est définie dans la revendication indépendante de procédé 1 et la revendication indépendante de dispositif 12. Les modes de réalisations privilégiés sont définis dans les revendications dépendantes 2 à 11 et 13.

Selon un aspect de l'invention, une machine électrique comprend une machine électrique inversée et au moins une machine électrique synchrone équipée du dispositif d'estimation.

L'invention sera mieux comprise et d'autres avantages apparaîtront à la lecture de la description détaillée d'un mode de réalisation donné à titre d'exemple, description illustrée par le dessin joint dans lequel :

[Fig.1A] La figure 1A illustre schématiquement un procédé d'estimation de la position d'un rotor d'une machine électrique tournante selon l'invention.

[Fig.1B] La figure 1B représente les deux derniers étages d'une machine électrique tournante à plusieurs étages comprenant un dispositif d'estimation de la position du rotor à basse vitesse et à l'arrêt.

[Fig.1C] La figure 1C illustre schématiquement le procédé d'estimation de la position d'un rotor d'une machine électrique tournante selon une variante.

[Fig.2A] La figure 2A illustre schématiquement le procédé d'estimation dans une version plus complète, c'est-à-dire comprenant des étapes complémentaires de traitement du signal pour estimation de la position du rotor d'une machine électrique tournante selon l'invention.

[Fig.2B] La figure 2B représente les deux derniers étages d'une machine électrique tournante à plusieurs étages comprenant un dispositif d'estimation de la position du rotor dans une version plus complète, c'est-à-dire comprenant d'autres modules de traitement de signal, de la position du rotor d'une machine électrique tournante selon l'invention.

[Fig.2C] La figure 2C illustre schématiquement une étape d'évaluation 16 de la phase d'une porteuse schématisé dans la Fig. 2B.

[Fig.3] La figure 3 représente les repères équivalents de représentation d'un courant $i_{abc}$ en utilisant les transformations de Concordia ou de Clarke vers un repère stationnaire $(\alpha, \beta)$, permettant la conservation de puissance et de l'amplitude respectivement.

[Fig.4] La figure 4 est un spectre d'harmoniques d'un signal $i_{\alpha h}$; $i_{\beta h}$ de la machine principale lorsque le courant rotorique contient une harmonique de haute fréquence, notamment $f_{ex}$ dans cette application.

Par souci de clarté, les mêmes éléments porteront les mêmes repères dans les différentes figures.

Le terme « machine principale » désigne, ici, toute machine électrique tournante synchrone, dotée ou pas d'un ou de plusieurs amortisseurs. Le terme « excitatrice », désigne toute machine électrique tournante synchrone inversée par rapport à la machine principale. L'excitatrice est connectée à la machine principale par un pont de diodes tournantes également appelé redresseur de courant permettant d'obtenir un courant continu à partir d'un courant alternatif.

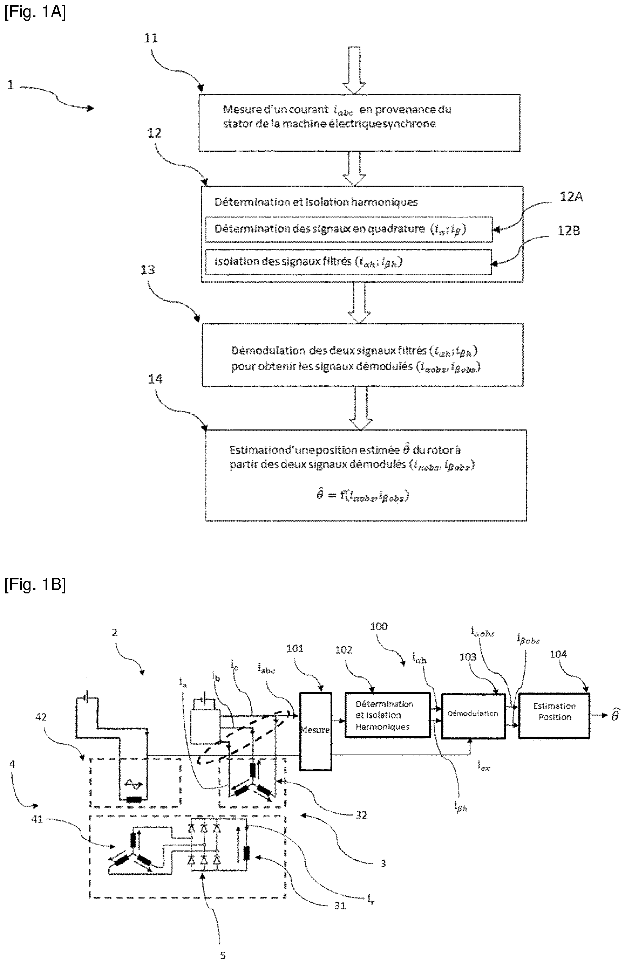

La figure 1A représente schématiquement un procédé d'estimation 1 d'une position estimée $\hat{\theta}$ d'un rotor 31 de machine principale 3 au sein des deux derniers étages d'une machine électrique tournante 2 composée de la machine principale 3, d'une excitatrice 4 et d'un dispositif d'estimation 100, représenté en figure 1B, de la position d'un rotor de machine électrique synchrone.

Le procédé d'estimation 1 de la position d'un rotor de machine principale mesure un courant $i_{abc}$ circulant au niveau du stator 32 et d'un courant $i_{ex}$ en provenance d'une excitatrice 4 mesuré au niveau d'un stator 42 de l'excitatrice 4 qui est un courant alternatif monophasé d'une fréquence constante $f_{ex}$. Le procédé d'estimation 1 de la position d'un rotor de machine électrique synchrone comprend les quatre étapes suivantes :

- Une étape de mesure 11 d'un courant $i_{abc}$ circulant dans le stator 32 de la machine principale 3 et, éventuellement, d'un courant $i_{ex}$ en provenance de l'excitatrice 4 au niveau du stator 42. Le courant $i_{abc}$ est un courant triphasé $i_a$,

$i_b$, $i_c$ de même fréquence $f_e$ de la machine principale 3 déphasé de 120 degrés. L'étape de mesure 11 permet également d'éliminer le bruit de mesuré en même temps que le courant $i_{abc}$. De plus, il peut être envisagé, suivant certaines conditions, de mesurer uniquement deux phases du courant statorique et d'en déduire le troisième suivant la loi de phases des courants triphasés :

$$i_a + i_b + i_c = 0$$

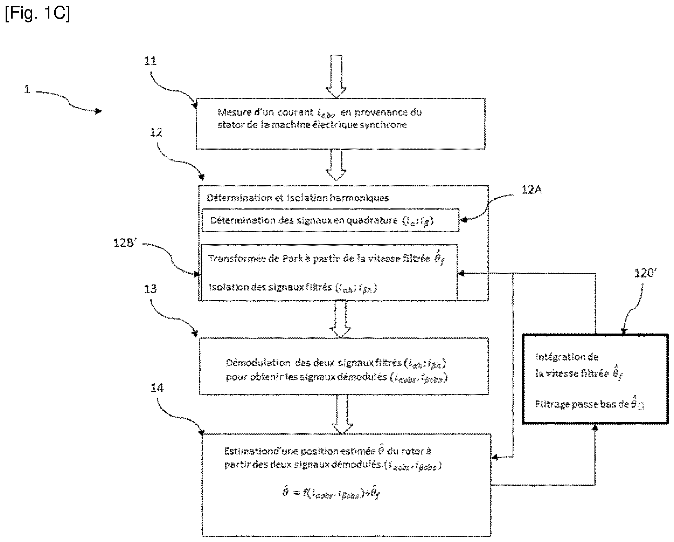

- Une étape de détermination et d'isolation harmoniques 12 permettant d'obtenir deux signaux filtrés $i_{\alpha h}$; $i_{\beta h}$ à partir du courant $i_{abc}$. L'étape de détermination et d'isolation 12 comprend des étapes de détermination 12A de deux signaux en quadrature $i_\alpha$; $i_\beta$ à partir du courant $i_{abc}$ du stator 32 selon un repère stationnaire et d'isolation 12B des deux signaux en quadrature $i_\alpha$; $i_\beta$ afin d'obtenir deux signaux filtrés $i_{\alpha h}$; $i_{\beta h}$. Plus précisément, le courant $i_{abc}$ est transformé dans un repère stationnaire $(\alpha, \beta)$ permettant de modéliser un système triphasé. Préférentiellement, le courant $i_{abc}$ est transformé dans le repère $(\alpha, \beta)$ par une transformation de Clarke dans un but de conservation de puissance et peut être transformé dans le repère $(\alpha, \beta)$ par une transformation de Concordia dans un but de conservation d'amplitude. Avantageusement, les machines polyphasées, comme par exemple hexaphasée, ont des transformations équivalentes vers un repère stationnaire, qui permettent de garder applicable l'invention. Les deux signaux sont filtrés lors de l'étape d'isolation 12B de façon à isoler seulement des harmoniques d'intérêt. Les deux signaux filtrés obtenus, qui représentent l'image des harmoniques d'intérêt pour l'homme du métier, sont ainsi nommés $i_{\alpha h}$; $i_{\beta h}$. A titre d'exemple, l'isolation 12B des deux signaux filtrés $i_{\alpha h}$; $i_{\beta h}$ à partir des deux signaux en quadrature $i_\alpha$; $i_\beta$ peut-être effectué à l'aide de filtre passe bande ou de filtre passe haut. Néanmoins, tout moyen ayant la fonction d'éliminer les signaux en basse fréquence au profit des signaux de haute fréquence et/ou permettant d'éliminer toutes les perturbations en provenance de l'environnement de la machine principale 3 peut être pris en considération lors de l'isolation 12B des deux signaux filtrés $i_{\alpha h}$; $i_{\beta h}$. A titre d'exemple, l'utilisation d'une transformation en fréquence, comme la transformation de Park, et un filtrage numérique afin d'isoler les harmoniques à une fréquence qui n'évolue pas dans le temps malgré la mise en rotation de la machine, comme représenté en figure 1C présente cette fonction d'élimination des signaux en basse fréquence au profit des signaux de haute fréquence.

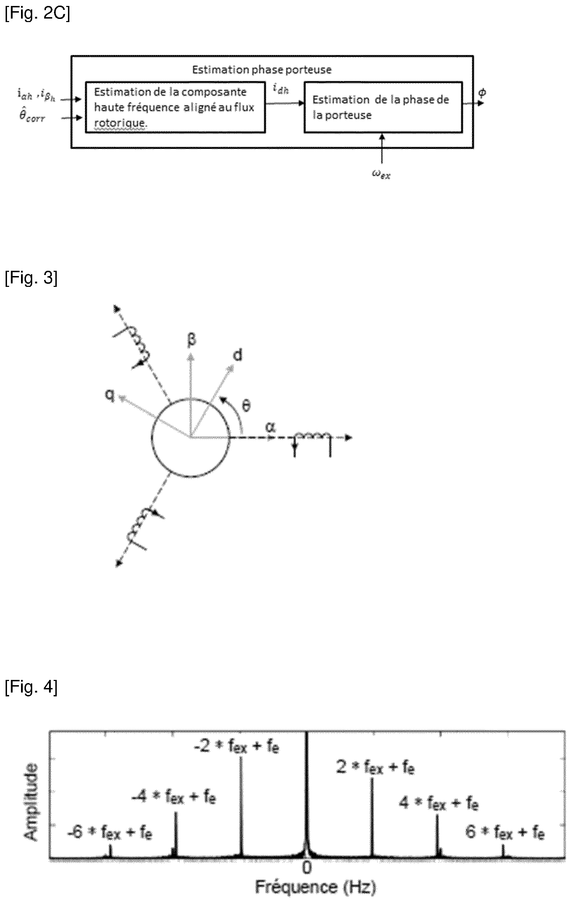

- Les deux signaux filtrés $i_{\alpha h}$; $i_{\beta h}$ sont avantageusement, des signaux ou harmoniques dont la fréquence combine la fréquence de fonctionnement $f_{ex}$ de l'excitatrice 4 ou d'un de ses multiples et la fréquence $f_e$ de la machine principale 3 comme le montre la figure 4. Préférentiellement, les deux signaux filtrés $i_{\alpha h}$; $i_{\beta h}$ ont une fréquence de la forme $f_e \pm 2 * f_{ex}$. Néanmoins, il peut être envisagé d'utiliser des signaux filtrés avec une forme différenciée telle que $f_e \pm 4 * f_{ex}$ ou encore $f_e \pm 6 * f_{ex}$. Les deux signaux filtrés $i_{\alpha h}$; $i_{\beta h}$ forment alors un couple d'harmoniques centrée autour de la composante fondamentale. Ainsi, les deux signaux filtrés $i_{\alpha h}$; $i_{\beta h}$ ont une fréquence qui peut être définie selon la formule suivante :

$$f_e \overset{+}{\_} n * f_{ex}$$

où n représente un nombre entier relatif pair, c'est-à-dire le nombre des paires de pôles au stator.

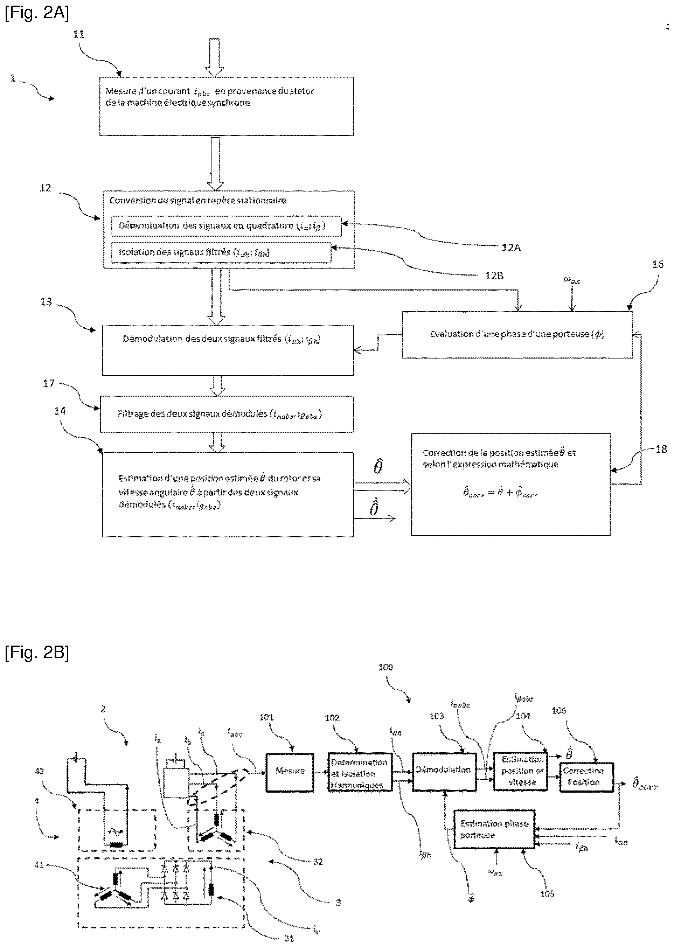

- Une étape de démodulation 13 des deux signaux filtrés $i_{\alpha h}$; $i_{\beta h}$ afin d'obtenir deux signaux démodulés $i_{\alpha obs}$, $i_{\beta obs}$. Afin de démoduler les deux signaux filtrés $i_{\alpha h}$; $i_{\beta h}$, l'étape de démodulation 13 utilise, par exemple, une mesure du courant de l'excitatrice $i_{ex}$ qui peut être déterminée au niveau du stator 42 de l'excitatrice 4 lors de l'étape de mesure 11 ou alors une estimation d'une porteuse de pulsation $\omega_{ex}$ de l'excitatrice 4 comme illustré dans les figures 2A et 2B.

Plus précisément, les deux signaux filtrés $i_{\alpha h}$; $i_{\beta h}$, ayant une amplitude A, peuvent s'écrire sous la forme :

$$\begin{bmatrix} i_{\alpha h} \\ i_{\beta h} \end{bmatrix} \approx A \begin{bmatrix} \cos(\theta) \\ \sin(\theta) \end{bmatrix} \sin(2\omega_{ex} t + \phi) \qquad (1)$$

Avec $\theta$ la position réelle du rotor 31 de la machine principale 3 et $\omega_{ex} = 2\pi f_{ex}$, la pulsation du courant de l'excitatrice 4. Avec $\phi$, la phase de l'harmonique du courant induite au rotor 31, harmonique que l'on appellera porteuse.

La démodulation observée consiste à éliminer le terme $\sin(2\omega_{ex} t + \phi)$ de l'équation (1).

Une manière de réaliser la démodulation consiste à multiplier l'équation (1) par un signal qui émule le signal de la porteuse. Ce signal doit avoir la fréquence et la phase de la porteuse. Or, en sachant que la porteuse ne peut pas être mesurée, le signal peut être reconstruit à partir de la mesure du courant de l'excitatrice $i_{ex}$. Un exemple de simple traitement du courant d'excitation pour reconstruction de la porteuse peut être :

$$\sin\left(2\omega_{ex}t + \hat{\phi}\right) \approx \frac{4|i_{ex}|}{I_{ex}} - 1$$

Avec $I_{ex}$ l'amplitude « peak to peak » du courant d'excitation et $\hat{\phi}$ la phase approchée de la porteuse ainsi obtenue.

Afin de permettre à l'Homme du métier de maîtriser plus précisément la phase $\phi$ de la porteuse, d'autres solutions sont envisageables comme par exemple l'utilisation d'un observateur prenant en compte la dynamique d'un redresseur 5, représenté en figure 1B, permettant d'obtenir un courant continu à partir d'un courant alternatif et du circuit du rotor 31 de la machine principale 3, représentée en figure 1B.

Un autre filtrage des deux signaux démodulés $i_{\alpha obs}$, $i_{\beta obs}$, représentant les deux signaux filtrés $i_{\alpha h}$; $i_{\beta h}$ après avoir été démodulés, appelé $H_F(s)$ est alors appliqué afin d'obtenir seulement l'information basse fréquence. Nous obtenons alors la formule suivante pour les deux signaux démodulés $i_{\alpha obs}$, $i_{\beta obs}$ :

$$\begin{bmatrix} i_{\alpha obs} \\ i_{\beta obs} \end{bmatrix} = H_F(s)\left(2\begin{bmatrix} i_{\alpha h} \\ i_{\beta h} \end{bmatrix}\sin\left(2\omega_{ex}t + \hat{\phi}\right)\right) \qquad (2)$$

Le signal à filtrer dans l'équation (2) peut alors être développée à l'aide de la formule (1) comme suit :

$$\begin{bmatrix} i_{\alpha h} \\ i_{\beta h} \end{bmatrix}\sin\left(2\omega_{ex}t + \hat{\phi}\right) = A\begin{bmatrix} \cos(\theta) \\ \sin(\theta) \end{bmatrix}\sin(2\omega_{ex}t + \phi)\sin\left(2\omega_{ex}t + \hat{\phi}\right) \quad (3)$$

Ainsi, par l'intermédiaire des formules trigonométriques, il est possible de mettre en évidence la composante basse fréquence qui est obtenue suite au filtrage dans l'équation (2) :

$$\begin{bmatrix} i_{\alpha h} \\ i_{\beta h} \end{bmatrix}\sin\left(2\omega_{ex}t + \hat{\phi}\right) = \frac{A}{2}\begin{bmatrix} cos(\theta) \\ sin(\theta) \end{bmatrix}\left(sin(\phi - \hat{\phi}) - cos\left(4\omega_{ex}t + \phi + \hat{\phi}\right)\right) \quad (4)$$

Or, comme dit précédemment, la phase approchée $\hat{\phi}$ permettant théoriquement de compenser la phase $\phi$ présent au sein de la porteuse estimée, le sinus de leur différence est idéalement équivalent à $sin(\phi - \hat{\phi}) \approx sin(0) = 1$.

Ainsi, la formule (4) devient alors :

$$\begin{bmatrix} i_{\alpha h} \\ i_{\beta h} \end{bmatrix}\sin\left(2\omega_{ex}t + \hat{\phi}\right) = \frac{A}{2}\begin{bmatrix} cos(\theta) \\ sin(\theta) \end{bmatrix}\left(1 - cos\left(4\omega_{ex}t + \phi + \hat{\phi}\right)\right) \quad (5)$$

De cette manière, il est possible d'obtenir les deux signaux démodulés $i_{\alpha obs}$, $i_{\beta obs}$ à partir des formules (5) et (2) en appliquant un filtrage, comme par exemple un filtre passe bas, synonyme de l'information sur la position réelle $\theta$ du rotor 31 de la machine principale 3 :

$$\begin{bmatrix} i_{\alpha obs} \\ i_{\beta obs} \end{bmatrix} = H_F(s)\left(2\begin{bmatrix} i_{\alpha h} \\ i_{\beta h} \end{bmatrix}\sin\left(2\omega_{ex}t + \hat{\phi}\right)\right) \approx A\begin{bmatrix} \cos(\theta) \\ \sin(\theta) \end{bmatrix} \quad (6)$$

Les deux signaux démodulés $i_{\alpha obs}$, $i_{\beta obs}$ sont donc de nouvelles représentations des deux signaux filtrés $i_{\alpha h}$; $i_{\beta h}$ privés de leur modulation haute fréquence.

- Une étape d'obtention 14 d'une position estimé $\hat{\theta}$ du rotor 31 de la machine principale 3 à partir des deux signaux démodulés $i_{\alpha obs}$, $i_{\beta obs}$ générés lors de l'étape de démodulation 13. L'étape d'obtention 14 permet de déterminer une position estimée à partir des deux signaux démodulés $i_{\alpha obs}$, $i_{\beta obs}$, notée $\hat{\theta}$. A titre d'exemple, la position estimée $\hat{\theta}$ lors de l'étape d'obtention 14 est réalisée selon l'expression mathématique suivante:

$$\hat{\theta} = \operatorname{atan}\left(\frac{i_{\beta obs}}{i_{\alpha obs}}\right) \qquad (7)$$

Après avoir estimé la position estimée $\hat{\theta}$ du rotor 31 de la machine principale 3, le procédé d'estimation 1 peut également comprendre une étape d'estimation d'une vitesse $\dot{\hat{\theta}}$ du rotor 31 de la machine principale 3 confondue au sein de l'étape d'obtention 14 de la position estimé $\hat{\theta}$. La vitesse $\dot{\hat{\theta}}$ du rotor 31 est la dérivée temporelle de la position estimée $\hat{\theta}$ du rotor 31.

Suivant une autre configuration, la position estimée $\hat{\theta}$ lors de l'étape d'obtention 14 peut être réalisée à l'aide d'une la boucle de verrouillage de phase ou d'un observateur, par exemple un observateur de type Luenberger, prenant en compte par exemple le modèle mécanique de la machine. Ces algorithmes minimisent l'écart d'estimation entre la position estimée $\hat{\theta}$, au pas d'itération précédant, et la position réelle $\theta$. Cet écart d'estimation est obtenu à partir des signaux démodulés $i_{\alpha obs}$, $i_{\beta obs}$ et la position estimée $\hat{\theta}$ obtenue à l'instant précédent. Ces algorithmes peuvent être avantageusement utilisés pour l'estimation de la vitesse $\dot{\hat{\theta}}$ en plus de l'obtention de la position estimée $\hat{\theta}$ du rotor 31.

En automatique, un observateur ou observateur d'état est une extension d'un modèle représenté sous forme de représentation d'état, c'est à dire un système dynamique, par l'intermédiaire de paramètres appelés variables d'état. Par définition, un observateur permet de reconstruire l'état du modèle observé à partir du système dynamique et des mesures d'autres grandeurs. Cette représentation permet de déterminer l'état du système à n'importe quel instant futur en connaissant l'état à l'instant initial et le comportement des variables d'état. Ainsi, il peut être envisagé d'utiliser, à la place de l'expression mathématique (7), un observateur, et de manière avantageuse un observateur de type Luenberger, au sein duquel parmi les variables d'états, on compte la position et la vitesse du système. Avantageusement, le modèle peut considérer la dynamique du couple résistant ou d'autres paramètres mécaniques mesurés ou connus de l'utilisateur. Le procédé d'estimation 1 de la position du rotor 31 est un procédé itératif, c'est-à-dire que le procédé d'estimation 1 peut être répété de manière périodique. Les quatre étapes successives de mesure 11 du courant $i_{abc}$, de détermination et d'isolation harmoniques 12, de démodulation 13 des deux signaux filtrés $i_{\alpha h}$; $i_{\beta h}$ et d'obtention 14 de la position estimée $\hat{\theta}$ peuvent donc être itérées à plusieurs reprises de manière à affiner la position estimée $\hat{\theta}$ et à réduire l'éventuelle erreur entre la position réelle $\theta$ et la position estimée $\hat{\theta}$ du rotor 31 de la machine principale 3.

La figure 1B représente schématiquement les deux derniers étages de la machine électrique tournante 2 composée de la machine principale 3, de l'excitatrice 4 accouplée à la machine principale 3 par l'intermédiaire d'un redresseur 5 triphasé tournant et d'un dispositif d'estimation 100 pour un fonctionnement à l'arrêt ou à faible vitesse. Le dispositif d'estimation de la position du rotor 31 de machine principale 3 est composé de quatre modules miroirs des quatre étapes du procédé d'estimation 1.

Un module de mesure 101, mettant en condition l'étape de mesure 11, apte à mesurer le courant $i_{abc}$ en provenance du stator 32 de la machine principale 3 et, éventuellement, apte à mesurer le courant $i_{ex}$ en provenance du stator 42 de l'excitatrice 4. Aussi, le module de mesure 101 permet également d'éliminer le bruit mesuré en même temps que le courant $i_{abc}$.

Un module de détermination et d'isolation harmoniques 102 permettant de mettre en condition l'étape de détermination et d'isolation harmoniques 12 présentée précédemment. Le module de détermination et d'isolation harmoniques 102 génère deux signaux filtrés $i_{\alpha h}$; $i_{\beta h}$ à partir du courant $i_{abc}$ non bruité obtenu du module de mesure 101. Plus précisément, le module de détermination et d'isolation harmoniques 102 permet de transformer courant $i_{abc}$ dans le repère stationnaire $(\alpha, \beta)$ par une transformation quelconque permettant de modéliser un système triphasé comme par exemple une transformation de Clarke ou une transformation de Concordia.

Un module de démodulation 103 des deux signaux filtrés $i_{\alpha h}$; $i_{\beta h}$, permettant d'obtenir deux signaux démodulés $i_{\alpha obs}$, $i_{\beta obs}$, met en condition l'étape de démodulation 13. Le module de démodulation 103 des deux signaux filtrés $i_{\alpha h}$; $i_{\beta h}$ est apte à recueillir la mesure du courant $i_{ex}$ du stator 42 de l'excitatrice 4 captée par le module de mesure 101 afin de générer les deux signaux démodulés $i_{\alpha obs}$, $i_{\beta obs}$ représentant l'information sur la position réelle $\theta$ du rotor 31 de la machine principale 3.

Les deux signaux démodulés $i_{\alpha obs}$, $i_{\beta obs}$ sont alors récupérés par un module d'obtention 104 de la position estimée $\hat{\theta}$ du rotor 31 de la machine principale 3. Le module d'obtention 104 met en condition l'étape d'obtention 14 de la position estimée $\hat{\theta}$ du rotor 31 de la machine principale 3. Ainsi, le module d'obtention 104 de la position estimée $\hat{\theta}$ est configuré pour déterminer, à partir des deux signaux démodulés $i_{\alpha obs}$, $i_{\beta obs}$, la position estimée $\hat{\theta}$ du rotor 31 suivant plusieurs moyens.

Ainsi, à titre d'exemple, la position estimée $\hat{\theta}$ du rotor 31 de la machine principale 3 peut être générée par le module d'obtention 104 selon l'expression mathématique (7) :

$$\hat{\theta} = \text{atan}\left(\frac{i_{\beta obs}}{i_{\alpha obs}}\right) \qquad (7)$$

Néanmoins, il peut être envisagé d'incorporer d'autres algorithmes ou procédures dans le module d'obtention 104 permettant de déterminer la position estimée $\hat{\theta}$, comme par exemple l'utilisation d'un algorithme de verrouillage de phase ou de l'observateur (non représenté) présenté précédemment en figure 1A, par exemple de type Luenberger prenant en compte le modèle mécanique de la machine.

A l'aide de ces quatre étapes comprenant l'étape de mesure 11 du courant $i_{abc}$ mis en condition par le module de mesure 101, l'étape de détermination et d'isolation harmoniques 12 mis en condition par le module de détermination et d'isolation harmoniques 102, l'étape de démodulation 13 des deux signaux filtrés $i_{\alpha h}$; $i_{\beta h}$ mis en condition par le module de démodulation 103 et l'étape de d'obtention 14 de la position estimée $\hat{\theta}$ mis en condition par le module d'obtention 104 de la position estimée $\hat{\theta}$, il est possible de déterminer la position du rotor 31 de la machine principale 3 ainsi que la vitesse.

En variante, l'étape de détermination et d'isolation harmoniques 12 peut inclure, à la place de l'étape 12B d'isolation des deux signaux en quadrature $i_{\alpha}$; $i_{\beta}$, une étape d'isolation avec action anticipative (ou « feedforward » en anglais)12B', représentée en figure 1C, permettant l'isolation des deux signaux filtrés $i_{\alpha h}$; $i_{\beta h}$ tout en induisant un changement de la fréquence des harmoniques d'intérêt. L'étape d'isolation avec action anticipative 12B' est précédée d'une étape 120' permettant le traitement de la vitesse actuellement estimée $\dot{\hat{\theta}}$ par le procédé. Il est à noter que la vitesse estimée $\dot{\hat{\theta}}$ correspond à une estimation de la fréquence électrique de la machine notée $f_e$. Dans le cas où cette estimation de la vitesse $\dot{\hat{\theta}}$ ne soit pas sans bruit, tout moyen ayant la fonction d'éliminer des variations haute fréquence sur la vitesse estimée $\dot{\hat{\theta}}$ peut être pris en considération lors de l'étape 120'. A titre d'exemple, un filtrage passe bas de la vitesse $\dot{\hat{\theta}}$ permet d'obtenir une vitesse estimée filtrée notée $\dot{\hat{\theta}}_f$, accompagné d'un intégrateur afin d'obtenir la phase de la vitesse filtrée $\hat{\theta}_f$ à la suite du filtrage passe bas peut être mis en place lors de l'étape 120' :

$$\hat{\theta}_f = \int \dot{\hat{\theta}}_f \, dt$$

L'utilisation, de manière anticipée, de la vitesse $\dot{\hat{\theta}}$ présente l'avantage d'assurer un meilleur conditionnement des signaux en quadrature $i_{\alpha}$; $i_{\beta}$ avant l'isolation de ces derniers. Dès lors, l'action anticipative dans l'étape 12B' permet une transformation des deux signaux en quadrature $i_{\alpha}$; $i_{\beta}$ en signaux filtrés $i_{\alpha h}$; $i_{\beta h}$ à partir de la phase de la vitesse filtrée $\hat{\theta}_f$. A titre d'exemple indicatif, cette transformation est une transformation de Park utilisant la phase de la vitesse filtrée $\hat{\theta}_f$ déterminée lors de l'étape 120'. A la différence de la transformation de Concordia ou de la transformation de Clarke, la transformation de Park présente l'intérêt de permettre un centrage de la fréquence des harmoniques en supprimant le terme lié à la fréquence $f_e$ de la machine principale 3 si on considère $\left(f_e - \dot{\hat{\theta}}_f\right) \approx 0$. Ainsi, les deux signaux filtrés $i_{\alpha h}$; $i_{\beta h}$ lors de l'étape d'isolation avec action anticipative 12B' forment un couple d'harmoniques centrée autour de la composante fondamentale dont la fréquence, libérée du déphasage lié à la fréquence $f_e$ de la machine principale 3, devient :

$$\pm\, n * f_{ex}$$

La phase de la vitesse filtrée $\hat{\theta}_f$ obtenue dans l'étape 120' est alors utilisée dans l'étape d'obtention 14 de la position estimée $\hat{\theta}$ afin de préserver la précision de l'estimation qui s'exprime alors, à titre d'exemple indicatif, selon la formule suivante :

$$\hat{\theta} = \mathrm{f}\!\left( i_{\alpha obs}, \; i_{\beta obs} \right) + \; \hat{\theta}_f$$

Où $\hat{\theta}_f$ représente l'intégration de la vitesse filtrée $\dot{\hat{\theta}}_f$.

A titre d'exemple préférentiel, l'étape d'obtention 14 est réalisée selon l'expression mathématique suivante :

$$\hat{\theta} = \mathrm{atan}\!\left( \frac{i_{\beta obs}}{i_{\alpha obs}} \right) + \; \hat{\theta}_f$$

Cependant, il peut exister certaines approximations comme par exemple au niveau de la phase de la porteuse du rotor 31 de la machine principale 3 ou encore pour le déphasage introduit lors des étapes de filtrage lors de la démodulation 13 des signaux de haute fréquence.

Ainsi, d'autres étapes, illustrées en figures 2A peuvent être ajoutées afin de supprimer les incertitudes citées.

La figure 2A représente schématiquement le procédé d'estimation 1 dans sa version la plus complète, c'est-à-dire le procédé d'estimation 1 illustré par la figure 1A au sein duquel des étapes supplémentaires ont été ajoutées. Ainsi, le procédé d'estimation 1, selon la figure 2A, comprend, les quatre étapes de mesure 11 du courant $i_{abc}$, de détermination et d'isolation harmoniques 12, de démodulation 13 des deux signaux filtrés $i_{\alpha h}$; $i_{\beta h}$ et d'obtention 14 de la position estimée $\hat{\theta}$ adoptant de nouvelles configurations :

- A la place de la mesure du courant $i_{ex}$ permettant la reconstruction de la porteuse, une estimation directe d'une phase $\hat{\phi}$ de la porteuse en connaissant la pulsation $\omega_{ex}$ de l'excitatrice 4 peut être envisagée. Cette phase $\hat{\phi}$ de la porteuse permet de s'affranchir de la mesure du courant $i_{ex}$ de l'excitatrice 4 tout en permettant de connaître au mieux la phase $\hat{\phi}$ de la porteuse. En effet, le procédé d'estimation 1 et le dispositif d'estimation 100 sont préférentiellement associés à une machine électrique tournante à trois étages. Cependant, par l'utilisation de l'estimation de la phase $\hat{\phi}$ de la porteuse à la place de la mesure du courant $i_{ex}$ de l'excitatrice 4, le procédé d'estimation 1 et le dispositif d'estimation 100 peuvent être associés à une machine électrique tournante dotée d'un seul étage ou à plus de deux étages.

En effet, afin de prédire au mieux la position du rotor 31 de la machine principale 3, la phase $\hat{\phi}$ de la porteuse doit être connue avec précision. Ainsi, une étape supplémentaire d'évaluation 16 de la phase $\hat{\phi}$ de la porteuse peut être introduite dans le procédé d'estimation 1. Plus précisément, l'étape de démodulation 13 est précédée de l'étape d'évaluation 16 de la phase $\hat{\phi}$ de la porteuse. Cette étape d'évaluation 16 de la phase $\hat{\phi}$ de la porteuse, est illustrée ci-après en figure 2C. Cette phase $\hat{\phi}$ de la porteuse est estimée à partir de la pulsation $\omega_{ex}$ de l'excitatrice 4, de la position estimée $\hat{\theta}$ lors d'une itération précédente du procédé d'estimation 1 et des signaux filtrés $i_{\alpha h}$, $i_{\beta h}$ lors de l'étape de détermination et d'isolation harmoniques 12. La porteuse peut être considérée comme une harmonique à haute fréquence obtenue au niveau du rotor 41 de l'excitatrice 4.

Ainsi, l'étape de démodulation 13 reçoit alors en entrée les signaux filtrés $i_{\alpha h}$, $i_{\beta h}$ contenant de manière plus précise l'information de la position du rotor 31 et la phase $\hat{\phi}$ de la porteuse pré-estimée en amont. Et l'étape de démodulation 13 peut se dispenser de la mesure du courant $i_{ex}$ de l'excitatrice 4.

- En théorie, l'étape de démodulation 13 permet d'obtenir deux signaux démodulés $i_{\alpha obs}$, $i_{\beta obs}$ idéaux, c'est-à-dire complètement épurées et utilisables pour déterminer la position estimée $\hat{\theta}$ du rotor 31 de la machine principale 3. Cependant, l'expérience tend à prouver que l'utilisation directe de la formule mathématique (7) permettant d'obtenir la position estimée $\hat{\theta}$ sur les deux signaux démodulés $i_{\alpha obs}$, $i_{\beta obs}$ contient des imperfections et peut provoquer de l'instabilité lorsque la position obtenue avec le procédé d'estimation 1 est utilisée dans la commande de la machine. Afin de réduire le bruit à la suite de l'étape de démodulation 13, une étape de filtrage 17 peut être mise en place. Cette étape de filtrage 17 nécessite en entrée les deux signaux démodulés $i_{\alpha obs}$, $i_{\beta obs}$ et permet de reconstruire une forme sinusoïdale aux deux signaux démodulés $i_{\alpha obs}$, $i_{\beta obs}$. Ainsi, l'étape de filtrage 17 est positionnée entre l'étape de démodulation 13 et l'étape d'obtention 14 de la position estimée. L'étape de filtrage 17 permet d'obtenir des signaux démodulés $i_{\alpha obs}$, $i_{\beta obs}$ purs, c'est à dire des signaux reconstruits des deux signaux démodulés $i_{\alpha obs}$, $i_{\beta obs}$ épurés de tous les effets non désirés comme, par exemple, le bruit induit par le passage par zéro des courants de phase. A titre d'exemple, cette étape de filtrage 17 peut être effectuée à l'aide d'un filtre passe bande adaptatif prenant en compte une information de fréquence électrique de la machine ou, elle peut être avantageusement ffectuée à l'aide d'un filtre de Kalman Etendu considérant leur modèle avec les propriétés des signaux en quadrature. Le filtre de Kalman peut être avantageusement utilisé pour estimation de la vitesse également.

Les perturbations éliminées, la formule mathématique (7) définie précédemment peut être utilisée sur les nouveaux signaux démodulés et filtrés $i_{\alpha obs}$, $i_{\beta obs}$ épurés lors de l'étape d'obtention 14 de la position estimée $\hat{\theta}$ du rotor 31 de la machine principale 3. Néanmoins, le procédé d'estimation 1 de la position estimée $\hat{\theta}$ introduit une série de déphasage sur la position estimée $\hat{\theta}$ pour chaque filtre utilisé. Par exemple, tout filtrage appliqué suite à l'étape de démodulation 13 induit un déphasage qui ne peut être ignoré dans le procédé d'estimation 1 car il est transfère automatiquement sur la position estimée $\hat{\theta}$. Pour être robuste, le procédé d'estimation 1 peut comprendre une étape de correction 18 de la position estimée $\hat{\theta}$. Cette étape de correction 18 est appliquée à la suite de l'étape d'obtention 14 de la position estimée $\hat{\theta}$ du rotor 31 de la machine principale 3 afin de corriger le déphasage induit. La position estimée $\hat{\theta}$ est alors corrigée dans l'étape de correction 18 avec la formule mathématique suivante :

$$\hat{\theta}_{corr} = \hat{\theta} + \hat{\phi}_{corr}$$

Où $\hat{\theta}_{corr}$ est la position corrigée du rotor 31 de la machine principale 3 et $\hat{\phi}_{corr}$ est une correction des retards sur l'estimation de la position du rotor 31 permettant d'aligner la position estimée $\hat{\theta}$ avec la position réelle du rotor 31 de la machine principale 3.

En outre, la correction des retards $\hat{\phi}_{corr}$ est, en réalité, une somme de plusieurs corrections considérées :

o Une correction de déphasage des filtres utilisés induit lors de la démodulation 13, noté $\hat{\phi}_F(\hat{\omega}_e)$. En effet, les deux signaux démodulés $i_{\alpha obs}$; $i_{\beta obs}$ sont généralement retardés par l'effet du filtrage. Ceci affecte alors la phase de la position estimée $\hat{\theta}$ du rotor 31 de la machine principale 3. Ainsi, afin de le rectifier cela, ce déphasage est calculé automatiquement et en temps réel en fonction de la vitesse $\dot{\hat{\theta}}$ de la machine principale 3.

◦ Une correction de déphasage dépendant des caractéristiques électromagnétiques de la machine électrique synchrone $\hat{\phi}_{lc}$ induit par le phénomène de saturation électromagnétique et/ou de variation de l'impédance du circuit statorique avec la température. En effet, chaque machine électrique tournante étant définie par sa propre architecture, elle comprend alors des effets de non-linéarité propre à cette dernière. De cette manière, pour deux machines électriques tournantes ayant un mode de fonctionnement identique, des écarts entre la position réelle et la position estimée peut être remarquée. La correction de déphasage dépendant des caractéristiques électromagnétiques de la machine électrique synchrone $\hat{\phi}_{lc}$ est donc propre à chaque machine électrique tournante dotée du dispositif d'estimation 100 et/ou du procédé d'estimation 1 de position du rotor 31 et est mise en place de manière empirique par exemple ou alors par simulation et/ou estimation lors de la mise en place du procédé d'estimation 1. Ainsi, la correction des retards $\hat{\phi}_{corr}$ peut être définie comme :

$$\hat{\phi}_{corr} = \hat{\phi}_F(\hat{\omega}_e) + \hat{\phi}_{lc}$$

La figure 2B représente les deux derniers étages de la machine électrique tournante 2 dotée du dispositif d'estimation 100 décrit en figure 1B dans sa version la plus complète, c'est-à-dire comprenant des modules supplémentaires permettant de mettre en condition le procédé d'estimation 1 complet décrit précédemment en figure 2A.

Comme énoncé en figure 1B, le dispositif d'estimation 100 comprend le module de mesure 101 du courant $i_{abc}$ en provenance du stator 32 de la machine principale 3, le module de détermination et d'isolation harmoniques 102 des deux signaux filtrés $i_{\alpha h}$; $i_{\beta h}$ à partir du courant $i_{abc}$, du module de démodulation 103 des deux signaux filtrés $i_{\alpha h}$; $i_{\beta h}$ et du module d'obtention 104 de la position estimée $\hat{\theta}$ du rotor 31.

A la suite de l'estimation de la position estimée $\hat{\theta}$ et de la vitesse $\dot{\hat{\theta}}$ du rotor 31, un module de correction 106 de la position estimée $\hat{\theta}$ peut être introduit. Ce module de correction 106, qui met en condition l'étape de correction 18 de la position estimée $\hat{\theta}$, permet d'évaluer la position corrigée $\hat{\theta}_{corr}$ qui fournit une estimation plus précise de la position du rotor 31 de la machine principale 3.

Le dispositif d'estimation 100 comprend également un module d'estimation 105 de la phase $\hat{\phi}$ de la porteuse. Afin d'estimer la phase $\hat{\phi}$, le module d'estimation 105 requiert la position corrigée $\hat{\theta}_{corr}$ de l'itération précédente ainsi que les deux signaux filtrés $i_{\alpha h}$, $i_{\beta h}$ et la pulsation $\omega_{ex}$ de l'excitatrice 4. Grâce à l'utilisation de ces trois paramètres, le module d'estimation 105 fournit la phase $\hat{\phi}$ de la porteuse au module de démodulation 103. Néanmoins, il peut être envisageable de remplacer la position estimée $\hat{\theta}$ à la place de la position corrigée $\hat{\theta}_{corr}$ dans le cas d'absence d'étape de correction 18 de la position estimée $\hat{\theta}$.

Le module de démodulation 103 recueille alors la phase $\hat{\phi}$ évaluée par le module d'estimation 105 ainsi que les deux signaux $i_{\alpha h}$, $i_{\beta h}$ déterminées par le module de détermination et d'isolation harmoniques 102, permettant ainsi de se passer de la mesure du courant $i_{ex}$ du stator 42 de l'excitatrice 4. Ainsi, le module de démodulation 103 des deux signaux filtrés $i_{\alpha h}$; $i_{\beta h}$ permet aussi d'obtenir les deux signaux démodulés $i_{\alpha obs}$, $i_{\beta obs}$ à partir de la porteuse de pulsation $\omega_{ex}$ de l'excitatrice 4.

De cette manière, une machine électrique comprenant l'excitatrice 4 et au moins une machine principale 3 peut être équipée du dispositif d'estimation 100 afin d'obtenir la position estimée $\hat{\theta}$ ou la position corrigée $\theta_{corr}$.

La figure 2C représente schématiquement l'étape d'évaluation 16 de la phase $\hat{\phi}$ de la porteuse en vue de permettre la mise en place de l'étape de démodulation 13.

Dans l'état de la technique, l'évaluation d'une phase $\hat{\phi}$ d'une porteuse se fait généralement à l'aide du courant mesuré au niveau du rotor 31. Cependant, cela implique l'utilisation d'un capteur supplémentaire dans le rotor 31, ce qui n'est pas possible dans le cadre d'une machine à plusieurs étages ou le courant rotorique n'est pas accessible.

Afin d'évaluer au mieux la phase $\hat{\phi}$ d'une porteuse sans mesure du courant d'excitation au niveau du stator 41 de l'excitatrice 4, les deux signaux filtrés $i_{\alpha h}$, $i_{\beta h}$, la pulsation $\omega_{ex}$ de la commande de l'excitatrice 4 ainsi que la position estimée $\hat{\theta}$ du rotor 31 de la machine principale 3 sont nécessaires. Avantageusement, la position estimée $\hat{\theta}$ peut être remplacée par la position corrigée $\theta_{corr}$ si cette position est disponible dans le procédé d'estimation 1.

Comme illustré dans le figure 2C, avant d'évaluer la phase $\hat{\phi}$, un signal $\hat{i}_{dh}$ est obtenu en utilisant les propriétés de la transformée de Clarke ou de Concordia combinant la position estimée $\hat{\theta}$ du rotor 31 et les deux signaux filtrés $i_{\alpha h}$, $i_{\beta h}$. Le signal $\hat{i}_{dh}$ obtenu est une estimation de la composante haute fréquence alignée au flux du rotor 31 de la machine principale 3.

Le signal $\hat{i}_{dh}$ obtenu est une image de la porteuse ayant la fréquence et la phase du signal induit au niveau du stator 32 de la machine principale 3. Il suffit de déterminer la phase du signal à la fréquence d'intérêt, dans un cas préférentiel $2\omega_{ex}$, pour obtenir la phase $\hat{\phi}$.

La figure 3 représente les transformations possibles du courant $i_{abc}$ vers un repère tournant ou un repère stationnaire. Le repère tournant est définit par un premier axe tournant d (direct) et un deuxième axe tournant q (quadrature) centrés au niveau de l'intersection du courant triphasé $i_a$, $i_b$, $i_c$. Comme le nom du repère l'indique, le premier axe tournant d et deuxième axe tournant q subissent une variation angulaire lié à la position $\theta$ utilisée pour la transformation. Une transformation dans un repère stationnaire composé par un premier axe fixe $\alpha$ et un deuxième axe fixe $\beta$ est réalisée, comme énoncé précédemment, à l'aide de la transformation de Clarke ou de la transformation de Concordia. Grâce à cette conversion, le courant $i_{abc}$ peut être défini par une composante suivant le premier axe fixe $\alpha$ et par une autre composante suivant le deuxième axe fixe $\beta$, c'est-à-dire les deux signaux en quadrature $i_\alpha$; $i_\beta$. Par ailleurs, il peut être envisagé d'utiliser d'autres types de transformation vers un repère stationnaire. Dès lors, un autre repère stationnaire pourrait être obtenu avec d'autres couples de signaux en quadrature.

Par l'intermédiaire de cette conversion, il est possible d'obtenir le spectre du courant $i_{\alpha\beta}$ de la machine principale 3 comme représentée en figure 4. Le spectre du courant permet d'illustrer les principales harmoniques des signaux en quadrature $i_\alpha$; $i_\beta$.

Comme énoncé précédemment, la fréquence des principales harmoniques est une combinaison de la fréquence de fonctionnement $f_{ex}$ de l'excitatrice 4 ou d'un de ses multiples et de la fréquence $f_e$ de la machine principale 3. Ainsi, les harmoniques peuvent avoir une fréquence de la forme $f_e \pm 2 * f_{ex}$ ou de la forme $f_e \pm 4 * f_{ex}$ ou encore de la forme $f_e \pm 6 * f_{ex}$.

## Revendications

**1.** Procédé d'estimation (1) de position d'un rotor (31) de machine électrique synchrone (3) sans injection de signaux, comprenant un rotor (31) et un stator (32), accouplée à une machine électrique synchrone inversée (4), comprenant un rotor (41) et un stator (42), assurant le rôle d'excitatrice, par l'intermédiaire d'un redresseur (5), le redresseur (5) étant connecté à l'excitation rotorique de la machine principale (3), le redresseur (5) étant connecté au rotor (41) de la machine électrique synchrone inversée (4), pour un fonctionnement à l'arrêt ou à faible vitesse, le procédé d'estimation (1) comprenant les étapes suivantes :

> a. Mesure (11) d'un courant $i_{abc}$ circulant dans le stator (32) de la machine électrique synchrone (3) ;
> b. Détermination (12A) de deux signaux en quadrature $i_\alpha$; $i_\beta$ selon un repère stationnaire à partir du courant $i_{abc}$ et isolation (12B) de deux signaux filtrés $i_{\alpha h}$; $i_{\beta h}$ à partir des deux signaux en quadrature $i_\alpha$; $i_\beta$ ;
> c. Démodulation (13) des deux signaux filtrés $i_{\alpha h}$; $i_{\beta h}$ afin d'obtenir deux signaux démodulés $i_{\alpha obs}$, $i_{\beta obs}$, l'étape de démodulation (13) des deux signaux filtrés $i_{\alpha h}$; $i_{\beta h}$ utilisant une mesure d'un courant $i_{ex}$ du stator (42) de la machine électrique synchrone inversée (4).;
> d. Obtention (14) d'une position estimée $\hat{\theta}$ du rotor (31) à partir des deux signaux démodulés $i_{\alpha obs}$, $i_{\beta obs}$.

**2.** Procédé d'estimation (1) selon la revendication 1, dans lequel la position estimée $\hat{\theta}$ dans l'étape d est réalisée selon l'expression mathématique suivante :

$$\hat{\theta} = \operatorname{atan}\left(\frac{i_{\beta obs}}{i_{\alpha obs}}\right)$$

**3.** Procédé d'estimation (1) selon la revendication 1, dans lequel la position estimée $\hat{\theta}$ dans l'étape d est réalisée à l'aide d'un observateur.

**4.** Procédé d'estimation (1) selon l'une des revendications précédentes, dans lequel les deux signaux filtrés $i_{\alpha h}$; $i_{\beta h}$ possèdent une fréquence combinant une fréquence de fonctionnement $f_{ex}$ de la machine électrique synchrone inversée (4) et une fréquence $f_e$ de la machine électrique synchrone (3) selon la formule suivante :

$$f_e \overset{+}{\underset{-}{}} n * f_{ex}$$

où n représente un nombre entier relatif pair.

**5.** Procédé d'estimation (1) selon l'une des revendications précédentes, dans lequel l'isolation (12B) des deux signaux filtrés $i_{\alpha h}$; $i_{\beta h}$ à partir des deux signaux en quadrature $i_\alpha$; $i_\beta$ est effectué à l'aide d'un filtre passe bande ou d'un filtre passe-haut.

**6.** Procédé d'estimation (1) selon l'une des revendications précédentes comprenant une étape de filtrage (17) des deux signaux démodulés $i_{\alpha obs}$, $i_{\beta obs}$ entre l'étape c et l'étape d, l'étape de filtrage (17) étant effectué à l'aide d'un filtre passe bande ou d'un Filtre de Kalman Etendu.

**7.** Procédé d'estimation (1) selon la revendication 2, comprenant une étape d'estimation de la vitesse $\dot{\hat{\theta}}$ du rotor (31) de la machine électrique synchrone (3) à partir de la position estimée $\hat{\theta}$ du rotor (31) de la machine électrique synchrone (3).

**8.** Procédé d'estimation (1) selon la revendication 7, comprenant une étape d'isolation avec action anticipative (12B') des deux signaux filtrés $i_{\alpha h}$; $i_{\beta h}$ à partir des deux signaux en quadrature $i_\alpha$; $i_\beta$ et d'une phase d'une vitesse filtrée $\dot{\hat{\theta}}_f$ du rotor (31), la vitesse filtrée $\dot{\hat{\theta}}_f$ du rotor (31) représentant la vitesse $\dot{\hat{\theta}}$ du rotor (31) filtrée.

**9.** Procédé d'estimation (1) selon l'une des revendications précédentes comprenant une étape de correction (18) de la position estimé $\hat{\theta}$ avec la formule mathématique suivante :

$$\hat{\theta}_{corr} = \hat{\theta} + \hat{\phi}_{corr}$$

où $\hat{\phi}_{corr}$ est une correction des retards sur l'estimation de la position et $\hat{\theta}_{corr}$ est une position corrigée du rotor (31) de la machine électrique synchrone (3).

**10.** Procédé d'estimation (1) selon la revendication précédente dans lequel la correction des retards $\hat{\phi}_{corr}$ est la somme d'une correction de déphasage des filtres utilisés $\hat{\phi}_F$ dans le procédé d'estimation (1) et d'une correction de déphasage dépendant des caractéristiques électromagnétiques de la machine électrique synchrone $\hat{\phi}_{LC}$.

**11.** Procédé d'estimation (1) selon l'une des revendications précédentes, le procédé d'estimation (1) pouvant être répété périodiquement, dans lequel l'étape de démodulation (13) est précédée d'une étape d'évaluation (16) d'une phase $\phi$ d'une porteuse à partir des signaux filtrés $i_{\alpha h}$; $i_{\beta h}$, d'une pulsation $\omega_{ex}$ de la machine électrique synchrone inversée (4) et de la position estimée $\hat{\theta}$ lors d'une précédente itération du procédé d'estimation (1), la porteuse étant obtenue au niveau du rotor (41) de la machine électrique synchrone inversée (4).

**12.** Dispositif d'estimation (100) de position d'un rotor (31) de machine électrique synchrone (3) sans injection de signaux, comprenant un rotor (31) et un stator (32), accouplée à une machine électrique synchrone inversée (4), la machine électrique synchrone inversée (4), comprenant un rotor (41) et un stator (42), assurant le rôle d'excitatrice, par l'intermédiaire d'un redresseur (5), le redresseur (5) étant connecté à l'excitation rotorique de la machine principale (3), le redresseur (5) étant connecté au rotor (41) de la machine électrique synchrone inversée (4), pour un fonctionnement à l'arrêt ou à faible vitesse, comprenant :

a) Un module de mesure (101) d'un courant $i_{abc}$ circulant dans le stator (32) de la machine électrique synchrone (3) ;

b) Un module (102) de détermination de deux signaux en quadrature $i_\alpha$; $i_\beta$ selon un repère stationnaire à partir du courant $i_{abc}$ et d'isolation harmoniques de deux signaux filtrés $i_{\alpha h}$; $i_{\beta h}$ à partir des deux signaux en quadrature $i_\alpha$; $i_\beta$;

c) Un module de démodulation (103) des deux signaux filtrés $i_{\alpha h}$; $i_{\beta h}$ à partir d'une mesure du courant $i_{ex}$ du stator (42) de la machine électrique synchrone inversée (4) ou d'une porteuse de pulsation $\omega_{ex}$ de la machine électrique synchrone inversée (4) afin d'obtenir deux signaux démodulés $i_{\alpha obs}$, $i_{\beta obs}$.

d) Un module d'obtention (104) configuré pour déterminer une position estimée $\hat{\theta}$ du rotor (31) de la machine électrique synchrone (3) à partir des deux signaux démodulés $i_{\alpha obs}$, $i_{\beta obs}$

13. Machine électrique comprenant une machine électrique inversée (4) et au moins une machine électrique synchrone (3) équipée du dispositif d'estimation (100) selon la revendication 12.

**Patentansprüche**

1. Verfahren zum Schätzen (1) der Position eines Rotors (31) einer elektrischen Synchronmaschine (3) ohne Signaleinspeisung, umfassend einen Rotor (31) und einen Stator (32), die mittels eines Gleichrichters (5) an eine invertierte elektrische Synchronmaschine (4), die einen Rotor (41) und einen Stator (42) umfasst, der als Erreger dient, gekoppelt ist, wobei der Gleichrichter (5) mit der Rotorerregung der Hauptmaschine (3) verbunden ist, wobei der Gleichrichter (5) mit dem Rotor (41) der invertierten elektrischen Synchronmaschine (4) für einen Stoppbetrieb oder einen Betrieb mit geringer Geschwindigkeit verbunden ist, wobei das Schätzverfahren (1) die folgenden Schritte umfasst:

a. Messen (11) eines Stroms $i_{abc}$, der in dem Stator (32) der elektrischen Synchronmaschine (3) zirkuliert;

b. Bestimmen (12A) von zwei Quadratursignalen $i_\alpha$; $i_\beta$ gemäß einem feststehenden Bezugspunkt anhand des Stroms $i_{abc}$ und Isolieren (12B) von zwei gefilterten Signalen $i_{\alpha h}$; $i_{\beta h}$ anhand der zwei Quadratursignale $i_\alpha$; $i_\beta$;

c. Demodulieren (13) der zwei gefilterten Signale $i_{\alpha h}$; $i_{\beta h}$, um zwei demodulierte Signale $i_{\alpha obs}$, $i_{\beta obs}$ zu erhalten, wobei der Schritt des Demodulierens (13) der zwei gefilterten Signale $i_{\alpha h}$; $i_{\beta h}$ eine Messung eines Stroms $i_{ex}$ des Stators (42) der invertierten elektrischen Synchronmaschine (4) nutzt;

d. Erhalten (14) einer geschätzten Position $\hat{\theta}$ des Rotors (31) anhand der zwei demodulierten Signale $i_{\alpha obs}$, $i_{\beta obs}$.

2. Schätzverfahren (1) nach Anspruch 1, wobei die geschätzte Position $\hat{\theta}$, die in dem Schritt d geschätzt wird, gemäß dem folgenden mathematischen Ausdruck erfolgt:

$$\hat{\theta} = \operatorname{atan}\left(\frac{i_{\beta obs}}{i_{\alpha obs}}\right)$$

3. Schätzverfahren (1) nach Anspruch 1, wobei die geschätzte Position $\hat{\theta}$ in dem Schritt d mit Hilfe eines Beobachters erfolgt.

4. Schätzverfahren (1) nach einem der vorhergehenden Ansprüche, wobei die zwei gefilterten Signale $i_{\alpha h}$; $i_{\beta h}$ eine Frequenz besitzen, die eine Betriebsfrequenz $f_{ex}$ der invertierten elektrischen Synchronmaschine (4) und eine Frequenz $f_e$ der elektrischen Synchronmaschine (3) gemäß der folgenden Formel kombiniert:

$$f_e \overset{+}{\underset{-}{}} n * f_{ex}$$

wobei n eine gerade relative ganze Zahl darstellt.

5. Schätzverfahren (1) nach einem der vorhergehenden Ansprüche, wobei das Isolieren (12B) der zwei gefilterten

Signale $i_{\alpha h}$; $i_{\beta h}$ anhand der zwei Quadratursignale $i_\alpha$; $i_\beta$ mit Hilfe eines Bandpassfilters oder eines Hochpassfilters erfolgt.

6. Schätzverfahren (1) nach einem der vorhergehenden Ansprüchen, umfassend einen Schritt (17) zum Filtern der zwei demodulierten Signale $i_{\alpha obs}$, $i_{\beta obs}$ zwischen dem Schritt c und dem Schritt d, wobei der Filterschritt (17) mit Hilfe eines Bandpassfilters oder eines erweiterten Kalman-Filters erfolgt.

7. Schätzverfahren (1) nach Anspruch 2, umfassend einen Schritt zum Schätzen der Geschwindigkeit $\Theta$ des Rotors (31) der elektrischen Synchronmaschine (3) anhand der geschätzten Position $\hat{\theta}$ des Rotors (31) der elektrischen Synchronmaschine (3).

8. Schätzverfahren (1) nach Anspruch 7, umfassend einen Schritt zum Isolieren mit antizipativer Aktion (12B') der zwei gefilterten Signale $i_{\alpha h}$; $i_{\beta h}$ anhand der zwei Quadratursignale $i_\alpha$; $i_\beta$ und einer Phase einer gefilterten Geschwindigkeit $\dot{\theta}_f$ des Rotors (31), wobei die gefilterte Geschwindigkeit $\dot{\theta}_f$ des Rotors (31) die gefilterte Geschwindigkeit $\dot{\theta}$ Rotors (31) darstellt.

9. Schätzverfahren (1) nach einem der vorhergehenden Ansprüche, umfassend einen Schritt zum Korrigieren (18) der geschätzten Position $\hat{\theta}$ mit der folgenden mathematischen Formel:

$$\hat{\theta}_{corr} = \hat{\theta} + \hat{\phi}_{corr}$$

wobei $\hat{\phi}_{corr}$ eine Korrektur der Verzögerungen der Schätzung der Position ist und $\hat{\theta}_{corr}$ eine korrigierte Position des Rotors (31) der elektrischen Synchronmaschine (3) ist.

10. Schätzverfahren (1) nach dem vorhergehenden Anspruch, wobei die Korrektur der Verzögerungen $\hat{\phi}_{corr}$ die Summe einer Phasendifferenzkorrektur der in dem Schätzverfahren (1) verwendeten Filter $\hat{\phi}_F$ und einer Phasendifferenz-korrektur in Abhängigkeit von den elektromagnetischen Merkmalen der elektrischen Synchronmaschine $\hat{\phi}_{LC}$ ist.

11. Schätzverfahren (1) nach einem der vorhergehenden Ansprüche, wobei das Schätzverfahren (1) periodisch wiederholt werden kann, wobei dem Schritt des Demodulierens (13) ein Schritt zum Auswerten (16) einer Phase $\hat{\phi}$ eines Trägers anhand der gefilterten Signale $i_{\alpha h}$; $i_{\beta h}$, einer Winkelfrequenz $\omega_{ex}$ der invertierten elektrischen Syn-chronmaschine (4) und der geschätzten Position $\theta$ bei einer vorausgehenden Iteration des Schätzverfahrens (1) vorausgeht, wobei der Träger an dem Rotor (41) der invertierten elektrischen Synchronmaschine (4) erhalten wird.

12. Vorrichtung zum Schätzen (100) der Position eines Rotors (31) einer elektrischen Synchronmaschine (3) ohne Signaleinspeisung, umfassend einen Rotor (31) und einen Stator (32), die mittels eines Gleichrichters (5) an eine invertierte elektrische Synchronmaschine (4) gekoppelt ist, wobei die invertierte elektrische Synchronmaschine (4) einen Rotor (41) und einen Stator (42) umfasst, der als Erreger dient, wobei der Gleichrichter (5) mit der Rotorerregung der Hauptmaschine (3) verbunden ist, wobei der Gleichrichter (5) mit dem Rotor (41) der invertierten elektrischen Synchronmaschine (4) für einen Stoppbetrieb oder einen Betrieb mit geringer Geschwindigkeit verbunden ist, umfassend:

a) ein Modul (101) zum Messen eines Stroms $i_{abc}$, der in dem Stator (32) der elektrischen Synchronmaschine (3) zirkuliert;
b) ein Modul (102) zum Bestimmen von zwei Quadratursignalen $i_\alpha$; $i_\beta$ gemäß einem feststehenden Bezugspunkt anhand des Stroms $i_{abc}$ und zum Isolieren von Harmonischen von zwei gefilterten Signalen $i_{\alpha h}$; $i_{\beta h}$ anhand der zwei Quadratursignale $i_\alpha$; $i_\beta$;
c) ein Modul (103) zum Demodulieren der zwei gefilterten Signale $i_{\alpha h}$; $i_{\beta h}$ anhand einer Messung des Stroms $i_{ex}$ des Stators (42) der invertierten elektrischen Synchronmaschine (4) oder eines Impulsträgers $\omega_{ex}$ der inver-tierten elektrischen Synchronmaschine (4), um zwei demodulierte Signale $i_{\alpha obs}$, $i_{\beta obs}$ zu erhalten,
d) ein Empfangsmodul (104), das dafür konfiguriert ist, eine geschätzte Position $\theta$ des Rotors (31) der elektrischen Synchronmaschine (3) anhand der zwei demodulierten Signale $i_{\alpha obs}$, $i_{\beta obs}$ zu bestimmen.

13. Elektrische Maschine, umfassend eine invertierte elektrische Maschine (4) und mindestens eine elektrische Synchronmaschine (3), die mit der Schätzvorrichtung (100) nach Anspruch 12 ausgestattet ist.

**Claims**

1. Method for estimating (1) the position of a rotor (31) of a synchronous electrical machine (3) without the injection of signals, comprising a rotor (31) and a stator (32) coupled to an inverted synchronous electrical machine (4), comprising a rotor (41) and a stator (42), acting as exciter, via a rectifier (5), the rectifier (5) being connected to the rotor excitation of the main machine (3), the rectifier (5) being connected to the rotor (41) of the inverted synchronous electrical machine (4) for operation when stopped or at low speed, the estimation method (1) comprising the following steps:

    a. measurement (11) of a current $i_{abc}$ circulating in the stator (32) of the synchronous electrical machine (3);
    b. determination (12A) of two signals in quadrature $i_\alpha$; $i_\beta$ according to a stationary reference frame from the current $i_{abc}$ and isolation (12B) of two filtered signals $i_{\alpha h}$; $i_{\beta h}$ from the two signals in quadrature $i_\alpha$; $i_\beta$;
    c. demodulation (13) of the two filtered signals $i_{\alpha h}$; $i_{\beta h}$ in order to obtain two demodulated signals $i_{\alpha obs}$, $i_{\beta obs}$, the step of demodulation (13) of the two filtered signals $i_{\alpha h}$; $i_{\beta h}$ using a measurement of a current $i_{ex}$ of the stator (42) of the inverted synchronous electrical machine (4);
    d. obtaining (14) of an estimated position $\hat{\theta}$ of the rotor (31) from the two demodulated signals $i_{\alpha obs}$, $i_{\beta obs}$.

2. Estimation method (1) according to claim 1, wherein the position $\hat{\theta}$ estimated in the step d is made according to the following mathematical expression:

$$\hat{\theta} = \mathrm{atan}\left(\frac{i_{\beta obs}}{i_{\alpha obs}}\right)$$

3. Estimation method (1) according to claim 1, wherein the estimated position $\hat{\theta}$ in the step d is done using an observer.

4. Estimation method (1) according to one of the preceding claims, wherein the two filtered signals $i_{\alpha h}$; $i_{\beta h}$ have a frequency combining an operating frequency $f_{ex}$ of the inverted synchronous electrical machine (4) and a frequency $f_e$ of the synchronous electrical machine (3) according to the following formula:

$$f_e \overset{+}{_-} n * f_{ex}$$

in which n represents an even relative integer number.

5. Estimation method (1) according to one of the preceding claims, wherein the isolation (12B) of the two filtered signals $i_{\alpha h}$; $i_{\beta h}$ from the two signals in quadrature $i_\alpha$; $i_\beta$ is performed using a bandpass filter or a high-pass filter.

6. Estimation method (1) according to one of the preceding claims, comprising a step of filtering (17) of the two demodulated signals $i_{\alpha obs}$, $i_{\beta obs}$ between the step c and the step d, the filtering step (17) being performed using a bandpass filter or an extended Kalman filter.

7. Estimation method (1) according to claim 2, comprising a step of estimation of the speed $\Theta$ of the rotor (31) of the synchronous electrical machine (3) from the estimated position $\hat{\theta}$ of the rotor (31) of the synchronous electrical machine (3).

8. Estimation method (1) according to claim 7, comprising a step of isolation with anticipative action (12B') of the two filtered signals $i_{\alpha h}$; $i_{\beta h}$ from the two signals in quadrature $i_\alpha$; $i_\beta$ and a phase of a filtered speed $\dot{\hat{\theta}}_f$ of the rotor (31), the filtered speed $\dot{\hat{\theta}}_f$ of the rotor (31) representing the speed $\dot{\hat{\theta}}$ of the rotor (31) when filtered.

9. Estimation method (1) according to one of the preceding claims, comprising a step of correction (18) of the estimated position $\hat{\theta}$ with the following mathematical formula:

$$\hat{\theta}_{corr} = \hat{\theta} + \hat{\phi}_{corr}$$

in which $\hat{\phi}_{corr}$ is a correction of the delays on the estimation of the position and $\hat{\theta}_{corr}$ is a corrected position of the rotor (31) of the synchronous electrical machine (3).

10. Estimation method (1) according to the preceding claim, wherein the correction of the delays $\hat{\phi}_{corr}$ is the sum of a phase-shift correction of the filters used $\hat{\phi}_F$ in the estimation method (1) and of a phase-shift correction dependent on the electromagnetic characteristics of the synchronous electrical machine $\hat{\phi}_{LC}$.

11. Estimation method (1) according to one of the preceding claims, the estimation method (1) being able to be repeated periodically, wherein the demodulation step (13) is preceded by a step of evaluation (16) of a phase $\hat{\phi}$ of a carrier from the filtered signals $i_{\alpha h}$; $i_{\beta h}$, of an angular frequency $\omega_{ex}$ of the inverted synchronous electrical machine (4) and of the estimated position $\hat{\theta}$ in a preceding iteration of the estimation method (1), the carrier being obtained at the rotor (41) of the inverted synchronous electrical machine (4).

12. Device for estimating (100) the position of a rotor (31) of a synchronous electrical machine (3) without the injection of signals, comprising a rotor (31) and a stator (32), coupled to a inverted synchronous electrical machine (4), the inverted synchronous electrical machine (4), comprising a rotor (41) and a stator (42), acting as exciter, via a rectifier (5), the rectifier (5) being connected to the rotor excitation of the main machine (3), the rectifier (5) being connected to the rotor (41) of the inverted synchronous electrical machine (4) for operation when stopped or at low speed, comprising:

a) a module (101) for measuring a current $i_{abc}$ circulating in the stator (32) of the synchronous electrical machine (3);
b) a module (102) for determining two signals in quadrature $i_\alpha$; $i_\beta$ according to a stationary reference frame from the current $i_{abc}$ and isolating harmonics of two filtered signals $i_{\alpha h}$; $i_{\beta h}$ from the two signals in quadrature $i_\alpha$; $i_\beta$;
c) a module (103) for demodulating the two filtered signals $i_{\alpha h}$; $i_{\beta h}$ from a measurement of the current $i_{ex}$ of the stator (42) of the inverted synchronous electrical machine (4) or of a carrier of angular frequency $\omega_{ex}$ of the inverted synchronous electrical machine (4) in order to obtain two demodulated signals $i_{\alpha obs}$, $i_{\beta obs}$;
d) an obtaining module (104) configured to determine an estimated position $\hat{\theta}$ of the rotor (31) of the synchronous electrical machine (3) from the two demodulated signals $i_{\alpha obs}$, $i_{\beta obs}$.

13. Electrical machine comprising an inverted electrical machine (4) and at least one synchronous electrical machine (3) equipped with the estimation device (100) according to claim 12.

[Fig. 1A]

11

1

12

Mesure d'un courant $i_{abc}$ en provenance du stator de la machine électrique synchrone

Détermination et Isolation harmoniques

Détermination des signaux en quadrature $(i_\alpha ; i_\beta)$    12A

Isolation des signaux filtrés $(i_{\alpha h} ; i_{\beta h})$    12B

13

Démodulation des deux signaux filtrés $(i_{\alpha h} ; i_{\beta h})$ pour obtenir les signaux démodulés $(i_{\alpha obs}, i_{\beta obs})$

14

Estimation d'une position estimée $\hat\theta$ du rotor à partir des deux signaux démodulés $(i_{\alpha obs}, i_{\beta obs})$

$$\hat\theta = f(i_{\alpha obs}, i_{\beta obs})$$

[Fig. 1B]

[Fig. 1C]

Mesure d'un courant $i_{abc}$ en provenance du stator de la machine électrique synchrone

Détermination et Isolation harmoniques

Détermination des signaux en quadrature $(i_\alpha; i_\beta)$

Transformée de Park à partir de la vitesse filtrée $\hat{\theta}_f$

Isolation des signaux filtrés $(i_{\alpha h}; i_{\beta h})$

Démodulation des deux signaux filtrés $(i_{\alpha h}; i_{\beta h})$ pour obtenir les signaux démodulés $(i_{\alpha obs}, i_{\beta obs})$

Estimation d'une position estimée $\hat{\theta}$ du rotor à partir des deux signaux démodulés $(i_{\alpha obs}, i_{\beta obs})$

$$\hat{\theta} = f(i_{\alpha obs}, i_{\beta obs}) + \hat{\theta}_f$$

Intégration de la vitesse filtrée $\hat{\theta}_f$

Filtrage passe bas de $\hat{\theta}$

EP 4 002 675 B1

[Fig. 2A]

[Fig. 2B]

18

[Fig. 2C]

Estimation phase porteuse

$i_{\alpha h}, i_{\beta h}$
$\hat{\theta}_{corr}$

Estimation de la composante haute fréquence aligné au flux rotorique.

$i_{dh}$

Estimation de la phase de la porteuse

$\phi$

$\omega_{ex}$

[Fig. 3]

[Fig. 4]

$-6 * f_{ex} + f_e$
$-4 * f_{ex} + f_e$
$-2 * f_{ex} + f_e$
$2 * f_{ex} + f_e$
$4 * f_{ex} + f_e$
$6 * f_{ex} + f_e$

Amplitude

0

Fréquence (Hz)

**EP 4 002 675 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 106959430 A
- CN 107134962 A
- WO 2012143458 A1